# EUROPEAN PATENT APPLICATION

(11) **EP 2 146 264 A1**
(43) Date of publication of application: **20.01.2010**
(21) Application number: 08736750.4
(22) Date of filing: 02.04.2008
(51) Int. Cl.: G05F 1/00, G01R 31/34

(54) **VOLTAGE SAG GENERATING EQUIPMENT**

(30) Priority: 11.04.2007 ES 200700948
(71) Applicant: Fundación CIRCE - Centro de Investigación de Recursos y Consumos Energéticos, María de Luna, 3 50018 Zaragoza (ES)
(72) Inventor: GARCIA GRACIA, Miguel, E-50018 Zaragoza (ES); LÓPEZ ANDÍA, Diego, E-50018 Zaragoza (ES); MARTÍN ARROYO, Susana, E-50018 Zaragoza (ES); ALONSO SÁDABA, Óscar, E-50018 Zaragoza (ES); COMECH MORENO, M. Paz, E-50018 Zaragoza (ES); GIMÉNEZ DE URTASÚN, Laura, E-50018 Zaragoza (ES); ARTAL SEVIL, Jesús Sergio, E-50018 Zaragoza (ES); SALLÁN ARASANZ, Jesús, 50018 Zaragoza (ES)
(74) Representative: Martin Santos, Victoria Sofia
(86) International application number: PCT/ES2008/070063
(87) International publication number: WO 2008/125718

(57) **Abstract**

The purpose of this invention is a device for generating voltage dips of a depth of up to 100% with adjustable variation switches and at as many levels of depth as wished, for connection in a wind farm or electricity generating system between the electrical energy evacuation line produced by the generators of the electrical installation in general or wind generation in particular and the system of electrical energy generation or wind turbine under test, where the voltage dip generator device controls and regulates the short circuit power detected by the electrical energy generating machinery or the wind turbine to be tested for voltage values exceeding 500 V and power exceeding 100 kW.

## Description

### OBJECT OF THE INVENTION

The object of this invention is a voltage dip generator device which can generate dips of up to 100% depth with adjustable variation switch, and with as many levels of depth as required in order to connect to a wind farm or electrical energy generation system between the evacuation line for the electricity produced by the generator(s) in general, and in particular wind energy, and the electricity generating system or wind turbine under test.

Due to its special configuration, the equipment for generating voltage dips controls and regulates the power of the short circuit detected by the electricity generating machine or the wind turbine for testing voltage values exceeding 500 V and powers exceeding 100kW.

Therefore, the apparatus is able to test a phase jump with a general quality factor "X/R" (where X is the reactance and R the resistance), controllable and different from the quality factor at the start of the test.

### BACKGROUND TO THE INVENTION

A voltage dip is defined as a brusque reduction in the voltage supply to a value situated between 90% and 1% of the declared voltage, followed by resumption of the voltage after a short time lapse.

According to convention, a voltage dip lasts form 10ms to 1 minute. The dept of a voltage dip is defined as the difference between the minimum effective voltage during the voltage dip and the declared voltage.

In the state of the art different devices exist for generating voltage dips in wind turbines which enable the results to be observed thus permitting predictions of the turbines' behaviour in the event of such dips.

The patent US5920132 is a system for generating dips for voltage low power levels, not applicable for electrical energy generation systems such as wind turbines which have voltage levels exceeding 500 V and power exceeding 100kW.

The patent US6285169 is a dip generator with impedance variation by means of connection/disconnection of taps at the outlet of an auto transformer. It is only viable with low power and its use is based on being light and portable with this being its objective, however, it is not applicable to electrical energy generating systems such as wind turbines.

Similarly, patent W02005069470 describes a device for generating light voltage dips and this is not applicable to electrical energy generating systems such as wind turbines which attain power levels of several megawatts.

Patent WO2006106106163 describes a device for generating voltage dips at low voltage. Patent WO2006108890 describes a voltage dip generator device which uses three power transformers without variable taps in parallel for varying the impedance of the short circuit branch.

Both devices are designed for the purpose of verifying the behaviour of electricity generating machinery such as wind turbines in the event of voltage dips. The first of these is only applicable to low voltage. In both cases dips are only achieved at three levels of 50, 66, and 75% of dip depth.

This invention overcomes all the previous disadvantages as it comprises a voltage dip generator device able to achieve depths of up to 100% with adjustable variation switches and at as many levels of depth as required, in addition to controlling and regulating the short circuit power in terminals of the generator or wind turbine to be tested, for voltage values exceeding 500 V and power levels exceeding 100kW, and it is able to test a phase jump with a general "X/R" quality factor, which is controllable and differs from the quality factor of the start of the test.

### DESCRIPTION OF THE INVENTION

This invention refers to a device for generating voltage dips of up to 100% depth able to test electricity generation systems at the actual installation connection point.

This test device permits selection of the dip depth as well as their duration in order to adapt to every type of fault likely to arise in an electrical network where the electricity generation system is connected.

The device for generating voltage dips is provided with an impedance divider formed by a serial branch followed by another in parallel comprising the following elements:
- Triphasic banks of impedances or three monophasic impedances, one for each phase placed serially in the evacuation line of the electricity generation system and prior to the parallel branch, the function of which is to restrict the short circuit current provided by the electricity network on which the test is carried out in such a way that the short circuit power is controlled and regulated in the generator, and ensuring that there are no disturbances to the network. Said impedances may represent a combination of resistances, reactances and/or transformers.
- Transformer with variable taps (or transformers with variable taps in parallel), in parallel when required with a set of impedances, with the possibility of an earth connection situated behind the serial bank of impedances and prior to connection to the electricity generation system. This transformer is provided with different adjustable taps in the first and/or secondary side, for regulating the transformation ratio thereof and to control the depth of the dip.
- Banks of triphasic impedances or three monophasic impedances, one for each phase, either variable or fixed, with these connecting to the earth. Said impedances together with the regulation of the transformer permit the voltage dip to be made at the required depth. Said impedances may represent a combination of resistances, reactances and/or transformers.
- Triphasic banks of impedances or three monophasic impedances one for each phase, variable or fixed, placed serially in the evacuation line of the electricity generating system. Its adequate connection prior to causing the voltage dip or following recovery of the dip, adds the possibility of testing phase jumps in the generation system. Said impedances may represent a combination of resistances, reactances and/or transformers.

In addition, the voltage dip generator device is provided with the requisite control elements for creating the voltage dip in an automated manner:
- Equipment for selecting the most appropriate transformer tap for creating the desired depth of dip.
- By-pass switch for the bank of serial impedances for direct connection of the network to the electricity generating system to which the testing equipment is connected.
- Connection switches of the parallel branch and for powering the transformer primary.
- Activator switch which connects the transformer secondary side with the impedance banks arranged in the secondary side thereof.
- Impedance selector switch. This switch selects the type of fault required, connecting the impedances to those phases on which a voltage dip is to be caused.
- Coupling and uncoupling switches situated at the head and at the outlet of the voltage dip generator device. Permits total insulation of the voltage dip generator device from the rest of the installation.
- Earth switch of the impedance banks arranged on the parallel branch.
- Control equipment which activates the closure and aperture of the switches according to the programmed sequence for generating dips.
- By-pass switch of the serial impedance bank for the simulation of phase jumps.

In addition, the equipment is provided with protection measures for the transformer which disconnect in the event of an internal fault in the transformer coils.

This equipment is able to generate triphasic, biphasic and monophasic voltage dips of depths ranging from 0% to 100% and of the desired duration, directly connecting the electricity generating terminals and the electrical energy collector system.

It permits direct testing at the exploitation location of the electrical energy generating system without disturbing the normal functioning of the other associated elements. It also permits phase jumps to be tested in the electricity generating system.

To summarise, this invention refers to a voltage dip generator device in electrical networks **characterised in that** it is able to produce voltage dips of up to 100% in depth, that is, reduce the voltage at a connection level or one per unit, to zero for voltage values exceeding 500 V and nominal power levels exceeding 100kW due to:
- One or various impedance banks between the collector system and the electricity generating system.
- A branch parallel to the branch where the bank of impedances located between the collector system and the energy generation system, which has one or various transformers with variable taps and one or various banks of impedances connected before the transformer primary side and in its secondary side which permits the desired depth of dip to be achieved by activating selector switches associated with each set of impedances.

### DESCRIPTION OF THE DRAWINGS

The present descriptive report is complemented by a set of plans illustrating a preferred embodiment of the invention but which is in no way restrictive.

Figure 1 shows a diagram of a preferred embodiment of the invention.

Figures 2 and 3 show diagrams of different embodiments of the invention.

### PREFERRED EMBODIMENT OF THE INVENTION

In the light of the foregoing, this invention refers to equipment for generating voltage dips of up to 100% depth which permits voltage dips to be created in voltage levels over 500V, connecting directly or through a transformer (which may or may not be the generation system's own transformer) to the terminals of the electricity generation system or the wind turbine in particular.

### First example of a preferred embodiment.

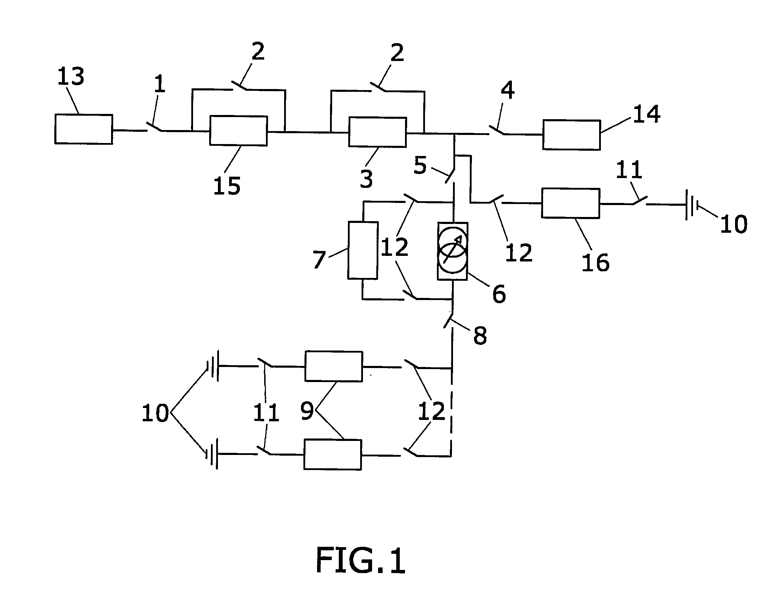

Figure 1 shows an electrical diagram of the elements which make up the voltage dip generator device in this first example of a preferred embodiment.

The voltage dip generator device has a coupling switch (1) from the collector system (13) which receives the energy produced by the generator system (14) which in this example of a preferred embodiment is a wind turbine.

Serially with the coupling switch (1) from the collector system (13) the voltage dip generator device is provided with one or various by-pass switches (2) in parallel with variable or fixed impedances (3) so that the by-pass switches (2) the coupling switch (1) and an uncoupling switch (4) are closed, and they permit direct connection between the collector system (13) and the electricity generating system (14) or wind turbine, as if voltage dip generator device had not been intercalated.

Having opened the by-pass switch (2) the electricity generating system (14) continues connecting to the collector system (13) however, through the variable or fixed impedances (3)in order not to disrupt the correct functioning of the rest of the wind farm during the test.

With the variable or fixed impedances (3) connected, the connection switch (5) of the branch in parallel is closed, powering the primary coil of a transformer (6) or various transformers in parallel arranged in this branch.

The transformer (6) acts as regulator from 1% to 100% of the impedances (9) arranged in the transformer (6) secondary side, with impedance selection switches (12) depending on whether a triphasic, biphasic or monophasic voltage dip is required, for which purpose these impedances are provided with various intermediate taps as well as intermediate taps placed before the transformer primary side.

Other impedances (7) situated parallel to the transformer, permit reduction of the equivalent impedance of the transformer parallel to these, according to the desired dip depth.

With the transformer (6) working in a vacuum, the activator switch (8) which connects the secondary of this transformer to the banks of variable or fixed impedances (9) of the transformer (6) secondary side, enabling connection of these to the earth (10) by means of a switch (11). By timing the opening and closing of this activating switch (8), the desired dip duration is obtained.

Thus the voltage dip acquires the desired depth by selecting, prior to the test, the bank of impedances (9) of the transformer (6) secondary and the transformation ratio or tap of the appropriate transformer (6).

A bank of impedances with variable or fixed jump phases, in the evacuation line of the electricity generating system (14) is connected prior to or subsequent to generating the voltage dip with the adequate synchronisation, which enables jump phases to be tested in the electrical power generation system (14) by modifying the General X/R quality factor which varies with respect to the start of the test and, therefore, causing a controllable phase jump.

The bank of impedances (15) of phase jump is provided with a parallel by-pass switch (2).

The discontinuous line in Figure 1 between the two branches of impedances (9) of the transformer(6) secondary, variable or fixed, indicates the possibility of adding other branches in parallel, with the same types of elements as those previously mentioned, for the generation of different types of voltage dips.

The dip generating equipment includes control equipment (not shown in the Figures) for activating the switches (11, 12) required for each type of dip (monophasic, biphasic, and triphasic), controlling their opening and closing times, as well as the activation switch (8), adapting them to the required dip duration, in addition to the transformer protection equipment and switchgear while the test is being carried out.

### Second example of a preferred embodiment

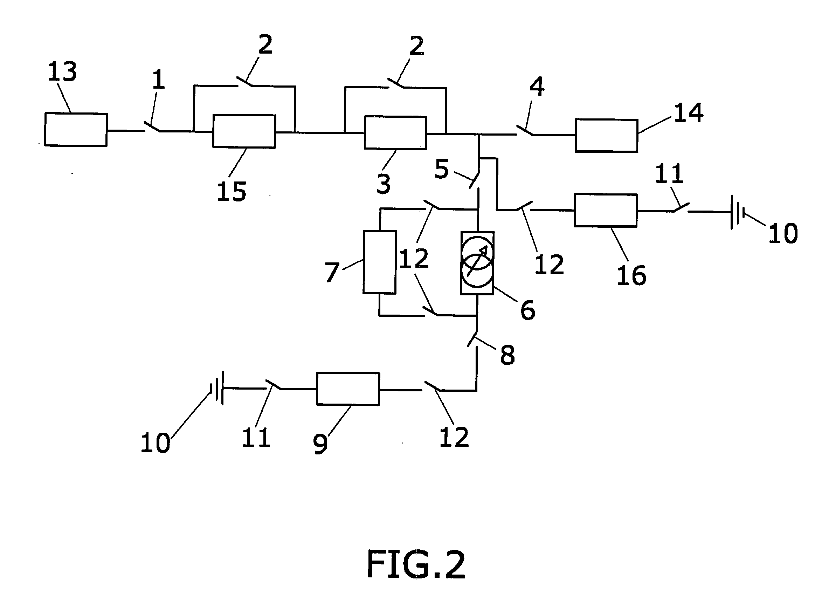

In this second example of a preferred embodiment shown in Figure 2, there is only one branch of variable or fixed impedances (9) in the transformer (6) secondary with the rest of the elements being those described in the first example of a preferred embodiment.

### Third example of a preferred embodiment

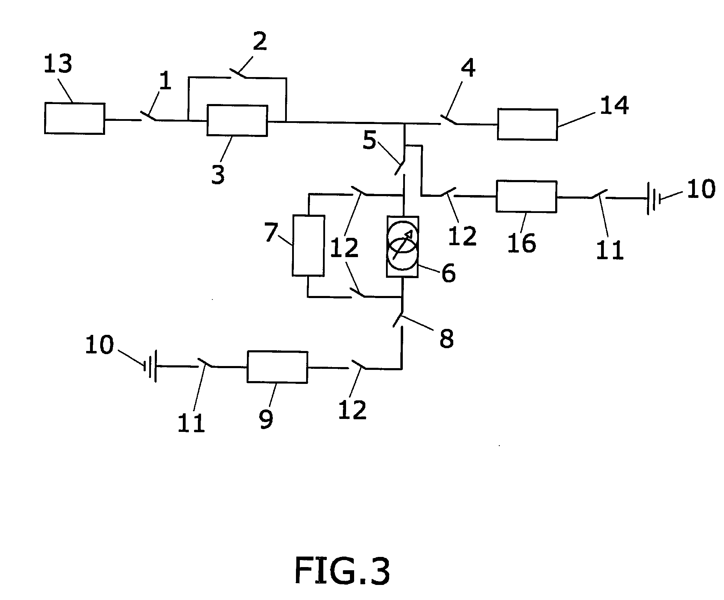

In this third example of a preferred embodiment shown in Figure 3, there is only one branch of variable or fixed impedances (9) in the transformer (6) secondary and there the bank of impedances (15) of the phase jump of the first example of a preferred embodiment in parallel with a by-pass switch (2) with the rest of the elements being those described in the first example of a

### preferred embodiment.

The essential nature of this invention is not altered by any variations in materials, form, size and arrangement of its component elements, which are described in a non-restrictive manner, with this being sufficient to proceed to its reproduction by an expert.

## Claims

1. Voltage dip generator device in electrical networks **characterised in that** it is able to produce voltage dips of up to 100% in depth, that is reduce the voltage from the connection level or one per unit, to zero for voltage values greater than 500 V and nominal powers exceeding 100kW due to:
• One or various impedance banks (3) between the collector system (13) and the electricity generating system (14).
• A branch parallel to the branch where the bank of impedances (3) is between the collector system (13) and the energy generation system (14), which has one or various transformers (6) with variable taps and one or various banks of impedances (16, 9)connected before the transformer primary and in its secondary which permits the desired depth of dip to be achieved by activating selector switches (12) associated with each set of impedances (16, 9).

2. Voltage dip generator device according to claim 1 **characterised in that** the impedances (3) enable regulation of the power to the short circuit to which the electricity generating system (14) is to be subjected.

3. Voltage dip generator device according to claim 1 **characterised in that** the banks of impedances (3) arranged between the collector system (13) and the electricity generating system (14) are provided with a branch with a by-pass switch (2) which permits direct connection between the generating system (14) and the collector system(13).

4. Voltage dip generator device according to claim 1 **characterised in that** between the collector system (13) and the banks of impedances (13) there is a coupling switch (1).

5. Voltage dip generator device according to claim 1 **characterised in that** between the generating system (14) and the parallel branch there is an uncoupling switch (4) which when it is open, permits the test to be carried out in a vacuum.

6. Voltage dip generator device according to claim 1 **characterised in that** at the start of the parallel branch there is a branch connection switch (5) between the collector system (13) and the generating system (14).

7. Voltage dip generator device according to claim 1 **characterised in that** the transformer(s) (6) situated on the parallel branch permit regulation from 1% to 100% of the nominal transformation ratio in order to adapt the impedances (9) arranged in the secondary side of the transformers (6).

8. Voltage dip generator device according to claim 5 **characterised in that** with the transformer(s) (6) working in a vacuum, the activating switch (8) connecting the secondary of the transformers (6) to the fixed or variable impedances (9) of the secondary transformers (6) which are then able to connect to an earth (10) by means of a switch (11), thus achieving the desired dip duration.

9. Voltage dip generator device according to claim 1 **characterised in that** impedances (7) situated parallel to each transformer (6), enables a reduction of the equivalent impedance of the transformers (6) which are parallel to these, according to the depth of dip required.

10. Voltage dip generator device according to claim 1 **characterised in that** a phase jump may be tested with an "X/R" quality factor, which is controllable and which differs from the quality factor at the start of the test, connecting a bank of impedances (15) of the phase jump in the evacuation line of the electricity generating system (14) where X is the reactance and R the resistance.

11. Voltage dip generator device according to claim 10 **characterised in that** it presents a bank of impedances (15) of jump phase in parallel with a by-pass switch (2).

12. Voltage dip generator device according to claim 1 **characterised in that** it is provided with control equipment appropriate for activating the switches (11, 12) required for each type of dip, either monophasic, biphasic or triphasic, controlling their opening and closing times as well as the activating switch (8) adapting these to the duration of the dip required.

13. Voltage dip generator device according to claim 1 **characterised in that** it is provided with transformer protection equipment and switchgear while the test is carried out.

14. Voltage dip generator device according to claim 1 **characterised in that** it is designed to test electricity generating machinery of wind turbine type.
